# EUROPEAN PATENT APPLICATION

(11) **EP 1 947 679 A1**
(43) Date of publication of application: **23.07.2008**
(21) Application number: 04726253.0
(22) Date of filing: 07.04.2004
(51) Int. Cl.: H01L 21/00

(54) **ATMOSPHERE REPLACEMENT PORT CONNECTING DEVICE FOR SUBSTRATE STORAGE VESSELS**

(71) Applicant: Right Mfg. Co., Ltd., Itabashi-ku Tokyo 174-8633 (JP)
(72) Inventor: NAGATA, Tatsuhiko, c/o RIGHT MFG, CO., LTD., Tokyo 1748633 (JP); YOSHIMURA, Takehiko, c/o RIGHT MFG, CO., LTD., Tokyo 1748633 (JP)
(74) Representative: Burbaud, Eric
(86) International application number: PCT/JP2004/004985
(87) International publication number: WO 2005/101484

(57) **Abstract**

A connecting device (100) is provided to a wafer carrier (10) for storing a wafer (1) and connected to a purge port (30) having a gas inlet (32) into which a gas for purging an atmosphere in the wafer carrier (10) flows. The connecting device (100) includes, a base (101); a communication port (102) formed in the base (101); and a close-contact mechanism that includes, a sealing ring (105), a groove (104), and a pressure-reducing passage (107) that communicates with the groove (104). The pressure in a space defined by the groove (104) and a peripheral edge (32A) of the gas inlet (32) is reduced at a position where the base (101) makes contact with the purge port (30), bringing the gas inlet (32) into close contact with the communication port (102).

## Description

### TECHNICAL FIELD

The present invention relates to a connecting device connected to an atmosphere purge port for purging the atmosphere in a wafer storage container (refer hereafter to as wafer carrier) for storing various substrates (refer hereafter to as wafers) such as a silicon wafer by introducing a desired gas (N₂ gas or the like) into the wafer carrier.

### BACKGROUND ART

Conventionally, with the wafer carrier of the type, a carrier door is opened by a load port. Then, a wafer is conveyed into a substrate-processing device having higher cleanliness by the substrate-processing device to undergo required processing.

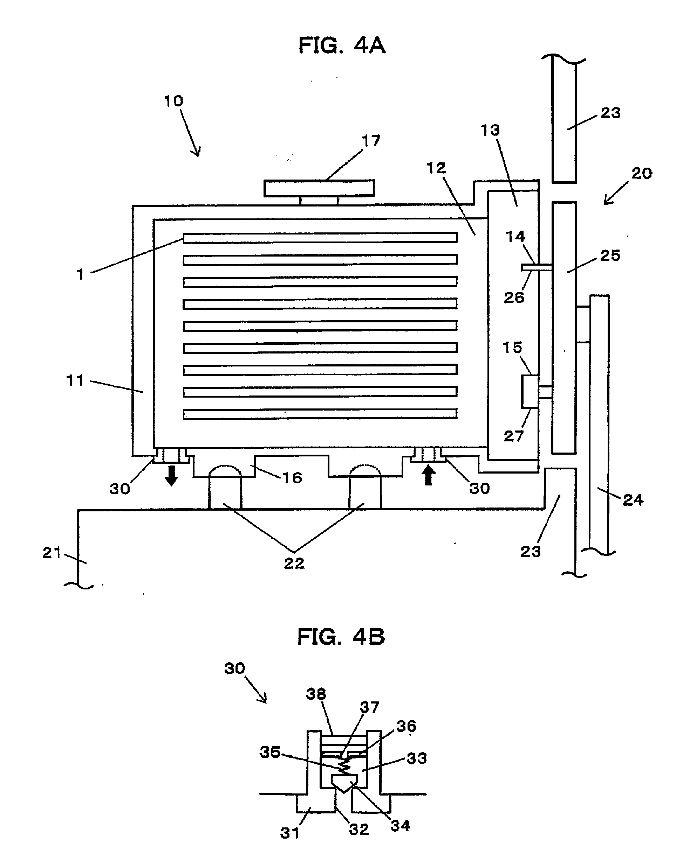

FIGS. 4A and 4B are schematic diagrams showing wafer carrier. FIG. 4A shows a state in which the wafer carrier is mounted on the load port, and FIG. 4B shows a purge port as will be described later. FOUP (Front Opening Unified Pod) and FOSB (Front Opening Shipping Box) are known as wafer carrier.

A wafer carrier 10 stores therein wafers 1 at predetermined intervals, and includes a carrier shell 11 having an open face 12 on one surface and a carrier door 13 engaged with the carrier shell 11. The carrier shell 11 has an upper portion formed with a robot flange 17 to be held by an automatic conveyor, not shown, and a lower portion formed with a base plate 16 having a V-shaped groove or notch formed therein.

Although the wafer carrier 10 is molded out of a high-function plastic, the plastic has a property of absorbing moisture, etc., thereby causing possible entering of moisture, etc. into the wafer carrier 10.

Moreover, although the carrier door 13 includes a packing, not shown, for maintaining the hermeticity of the wafer carrier 10, the hermeticity ensured by the packing is not perfect, thereby causing possible leakage of the atmosphere in the wafer carrier 10 to the outside.

Therefore, the humidity, oxygen concentration, etc. in the wafer carrier 10 could increase gradually.

Furthermore, when a photoresist is applied on the surface of the wafers 1, an organic solvent evaporated from the photoresist diffuses inside the wafer carrier 10, causing possible organic contamination of the atmosphere.

In order to prevent the rise in humidity and oxygen concentration and organic contamination in the wafer carrier 10, the wafer carrier 10 has a bottom formed with an atmosphere purge port (refer hereafter to as purge port) 30 for purging the atmosphere in the wafer carrier 10 by introducing N₂ gas or dry air into the wafer carrier 10.

The load port 20 includes a pedestal 21 on which the conveyed wafer carrier 10 is mounted, a kinematic pin 22 arranged on the pedestal 21 and for positioning the wafer carrier 10, a load-port door 25, a load-port door opening/closing mechanism 24 for opening/closing the load-port door 25, a wall surface 23, etc. The kinematic pin 22 engages with the notch formed in the base plate 16.

The load-port door 25 includes a registration pin 26 for positioning the carrier door 13 and a latchkey 27 that rotates to allow opening/closing of the carrier door 13. The career door 13 is formed with a registration-pin hole 14 and a latchkey hole 15. With the registration pin 26 inserted, the registration-pin hole 14 ensures positioning. With the latchkey 27 inserted, the latchkey hole 15 serves to open and close the carrier door 13.

Next, a description will be made about purging operation so called for purging the atmosphere in the wafer carrier 10 using the purge port 30.

As shown, for example, in FIG. 4B, the purge port 30 includes a base 31, a gas inlet 32 arranged in the base 31 and into which N2 gas or the like (refer hereafter to as purge gas) flows, a check valve 34, a valve chamber 33 for movably storing the check valve 34, a compression spring 35 for biasing the check valve 34 toward the gas inlet 32, a communication port 37, a support plate 36 for supporting the compression spring 35, a filter 38, etc.

The purge gas flows into the gas inlet 32 from a gas feed device, not shown. The force due to the flow rate of purge gas compresses the compression spring 35, and produces a clearance between the check valve 34 and the base 31. Derived from the clearance, the purge gas passes via the valve chamber 33 and the communication port 37 through the filter 38 to be introduced into the wafer carrier 10.

Now, the flow rate of purge gas and the time required for purging operation (refer hereafter to as purge time) will be described.

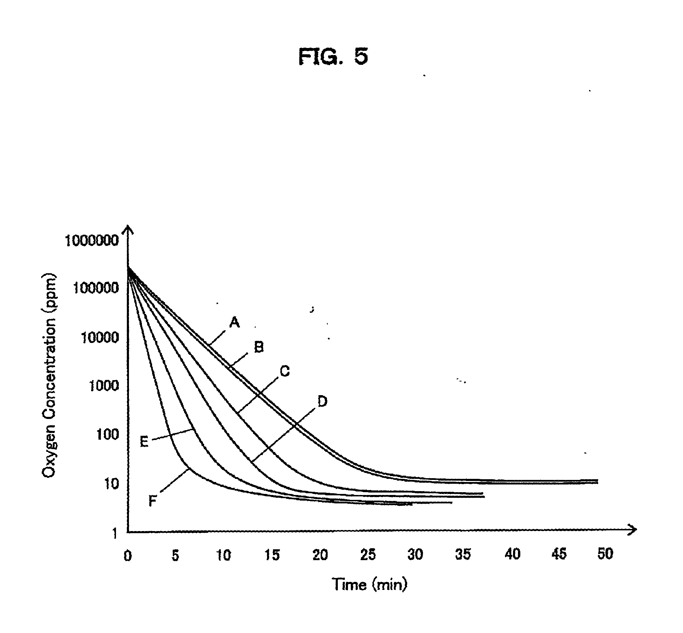

FIG. 5 is a chart showing a relationship between the flow rate of purge gas and the purge time.

Preferably, the oxygen concentration in the wafer carrier 10 is 10 ppm or less, for example. A curve A shows oxygen concentration when the flow rate of purge gas is 5 L/min and purge time required to arrive at this oxygen concentration. Similarly, curves B, C, D, E, and F show cases in which the flow rates are 10 L/min, 15 L/min, 20 L/min, 30 L/min, and 40 L/min, respectively. The curves A to F reveal that the purge time is longer when the flow rate of purge gas is smaller.

For the substrate-processing device, there was a demand to purge the atmosphere in the wafer carrier 10 in a short time, leading to the necessity of increasing the flow rate of purge gas. For example, in order to reduce the oxygen concentration in the atmosphere in the wafer carrier 10 to 10 ppm or less in about 5 minutes, the required flow rate of purge gas is about 40 L/min as shown by the curve F.

However, when the purge gas passes through the check valve 34 and the filter 38 arranged in the purge port 30, the filter 38 undergoes the pressure due to the flow rate of purge gas.

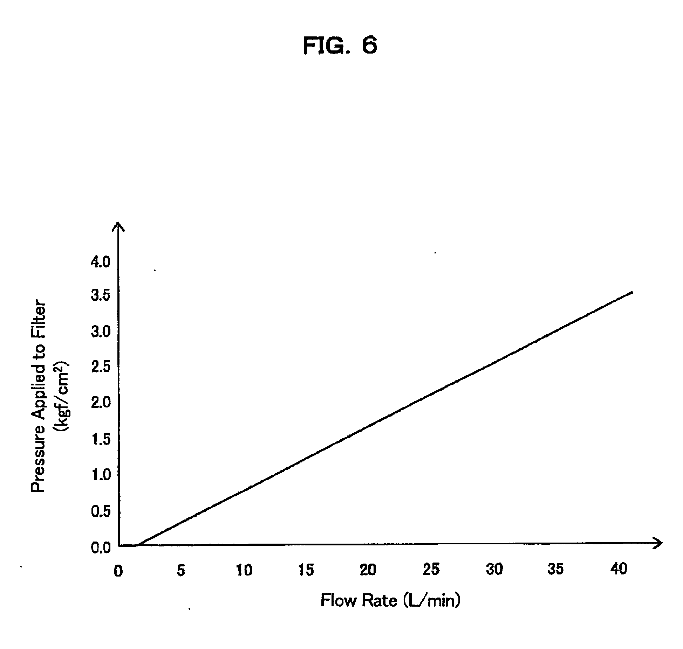

FIG. 6 is a chart showing a relationship between the flow rate of purge gas and the pressure applied to the filter 38.

As described above, in order to reduce the purge time to about 5 minutes, it is necessary to set the flow rate of purge gas at about 40 L/min. Then, a pressure P applied to the filter 38 is about 3.3 kgf/cm² as illustrated in the drawing.

The purge port 30 is connected to the gas feed device through, for example, a connection device, not shown. Then, since a force F generated in a cross-section area S (for example, 2.0 cm²) of a sealing part between the purge port 30 and the existing connection device has a relationship of F = P S, the force is given by F = 3.3 × 2 = 6.6 kgf.

This force F acts on the wafer carrier 10 in the direction from the bottom toward the top, thus becoming a force separating the purge port 30 and the existing connection device. As a consequence, the wafer carrier 10 may disengage from the kinematic pin 22.

This may cause vertical displacement of the position of the carrier door 13 provided to the wafer carrier 10, leading to occurrence of a problem of non-operation during opening/closing, etc.

JP-2003-017553-A (Patent Document 1) discloses in FIG. 5 a wafer carrier including a gas inlet arranged in the bottom of the wafer carrier, a lid arranged to cover the gas inlet and having an opening in one direction, and a gas feed means connected to the gas inlet. With the wafer carrier of Patent Document 1, however, the nonuse of the existing purge port results in modification of the configuration of the wafer carrier, leading to possible occurrence of a cost increase. Moreover, with the wafer carrier, the lid provided to the gas inlet undergoes the pressure due to the flow rate of purge gas, and is thus pushed up from below to above, leading to possible occurrence of positional instability.

### DISCLOSURE OF THE INVENTION

An object of the present invention is to provide a connecting device that allows stabilization of the wafer carrier and implementation of purging operation in a short time.

The first invention is directed to a connecting device provided to a wafer storage container for storing a wafer and connected to an atmosphere purge port having a gas inlet into which gas for purging an atmosphere in the wafer storage container flows, the connecting device including: a base; a communication port formed in the base; and a close-contact mechanism that brings the gas inlet into close contact with the communication port.

The second invention is characterized in that the close-contact mechanism includes: a sealing part arranged on a surface opposite to the atmosphere purge port; a groove formed in the opposite surface; and a pressure-reducing part that reduces the pressure in a space defined by the groove and a peripheral edge of the gas inlet at a position where the base makes contact with the atmosphere purge port.

The third invention is characterized in that the pressure-reducing part includes: a pressure-reducing passage that communicates with the groove; and a conveying part connected to the pressure-reducing passage, the conveying part conveying air in the space to the outside.

The fourth invention is characterized in that the sealing part includes a sealing ring arranged at a peripheral edge of the communication port.

The fifth invention is characterized in that the close-contact mechanism includes: a sealing part arranged on a surface opposite to the atmosphere purge port; a holding part that holds the atmosphere purge port; and a pressing part that presses the opposite surface against the atmosphere purge port held by the holding part.

The sixth invention is characterized in that the holding part includes: an engaging part that engages with a flange formed with the atmosphere purge port; a first cam part that drives the engaging part; and a first abutment that abuts on the cam part, wherein by displacing the first abutment in a state of abutting on the first cam part, the engaging part engages with the flange.

The seventh invention is characterized in that the pressing part includes: a moving part that moves the base; a second cam part that drives the moving part; and a second abutment that abuts on the second cam part, wherein by displacing the second abutment in a state of abutting on the second cam part, the moving part presses the base against the atmosphere purge port.

The eighth invention is characterized in that the first cam part and the second cam part are arranged coaxially, and are shifted in phase to drive the pressing part after driving the holding part.

The ninth invention is characterized in that the sealing part is disposed at a peripheral edge of the communication port.

According to the present invention, the gas inlet provided to the atmosphere purge port for purging the atmosphere in the wafer storage container and the communication port formed in the base are brought into close contact with each other by the close-contact mechanism. Therefore, even if the separating force due to the flow rate of purge gas occurs in the wafer storage container, the connecting device does not separate from the wafer storage container to stabilize the position of the wafer storage container. Moreover, the flow rate of purge gas can be increased to reduce the time required to purge the atmosphere in the wafer storage container.

### BRIEF DESCRIPTION OF THE DRAWINGS

FIG. 1 is a view showing a state in which a wafer carrier is mounted on a load port to which a connecting device according to an embodiment 1 of the present invention is provided;
FIG. 2 is an explanatory view showing the connecting device according to the embodiment 1 of the present invention;
FIGS. 3A to 3C are explanatory views showing a connecting device 200 according to an embodiment 2 of the present invention;
FIGS. 4A and 4B are schematic diagrams showing the wafer carrier;
FIG. 5 is a chart showing a relationship between the flow rate of purge gas and the purge time; and
FIG. 6 is a chart showing a relationship between the flow rate of purge gas and the pressure applied to a filter 38.

### PREFERRED MODE FOR CARRYING OUT THE INVENTION

Referring to the drawings, etc., the embodiments of the present invention will be described hereafter in more detail.

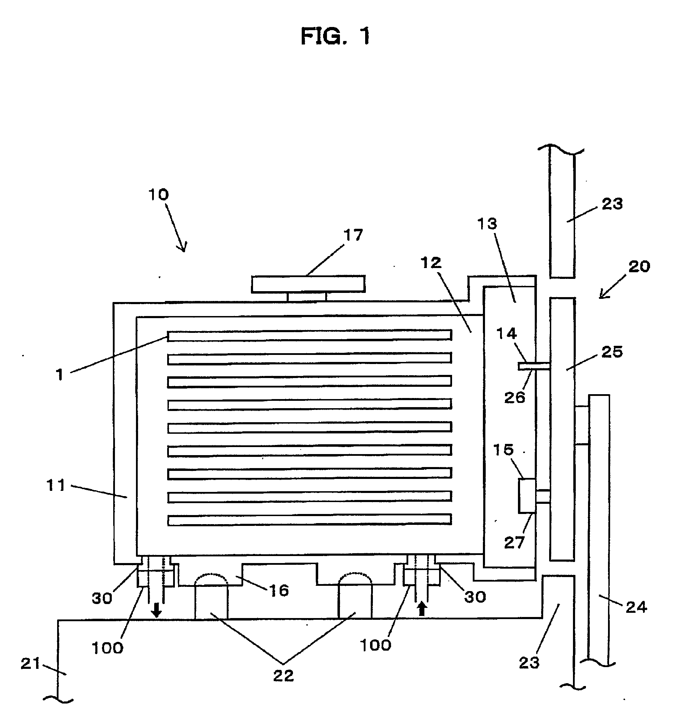

FIG 1 is a view showing a state in which a wafer carrier is mounted on a load port in which a connecting device according to the embodiment 1 of the present invention is arranged.

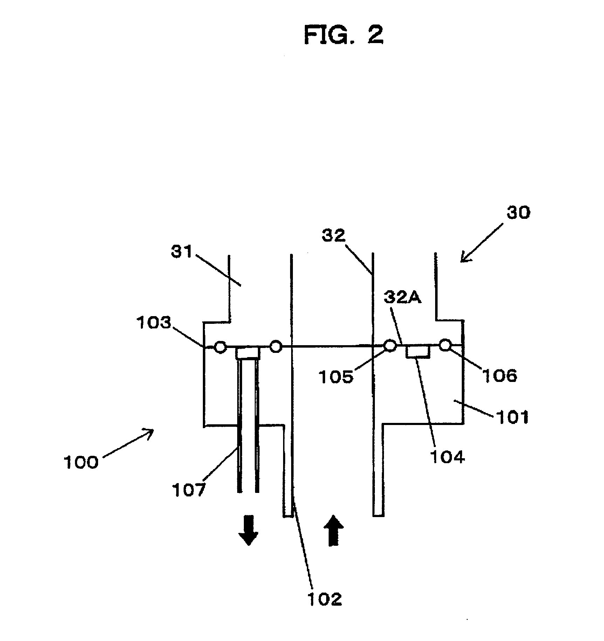

FIG 2 is an explanatory view showing the connecting device according to the embodiment 1 of the present invention.

As shown in FIG. 1, a connecting device 100 is arranged at a position of a purge port 30 of a wafer carrier 10 conveyed by an automatic conveyor, not shown.

The connecting device 100 is connected to the purge port 30 having a gas inlet 32 into which the purge gas for purging the atmosphere in the wafer carrier 10 flows.

As shown in FIG. 2, the connection device 100 includes a base 101 formed with a communication port 102, sealing rings 105 and 106 arranged on a surface 103 opposite the purge port 30, a groove 104 formed in the opposite surface 103, etc.

The connection device 100 includes a pressure-reducing part for reducing the pressure in a space defined by the groove 104 and a peripheral edge 32A of the gas inlet 32 at a position where the base 101 makes contact with the purge port 30. The pressure-reducing part includes a pressure-reducing passage 107 communicating with the groove 104, a vacuum pump, not shown, connected to the pressure-reducing passage 107 and for conveying air in the aforementioned space to the outside, etc.

The sealing rings 105 and 106 each are an O-ring or an X-ring, for example, wherein the sealing ring 105 is arranged at the peripheral edge of the communication port 102, and the sealing ring 106 is arranged outside the groove 104.

The groove 104 is annularly formed in the opposite surface 103 of the base 101. The groove 104 brings the gas inlet 32 into close contact with the communication port 102 by reducing the pressure in the aforementioned space with the vacuum pump or the like.

With the connection device 100, the pressure in the space defined by the groove 104 formed in the opposite surface 103 and the peripheral edge 32A of the gas inlet 32 is reduced at the position where the purge port 30 makes contact with the base 101 formed with the communication port 102. Thus, even if the separating force (for example, upward force of several kilograms-force or more) due to the flow rate of purge gas occurs in the wafer carrier 10, the connecting device 100 will not separate from the wafer carrier 10, allowing not only stabilization of the position of the wafer carrier 10, but also reduction in purge time required to purge the atmosphere in the wafer carrier 10 by increasing the flow rate of purge gas.

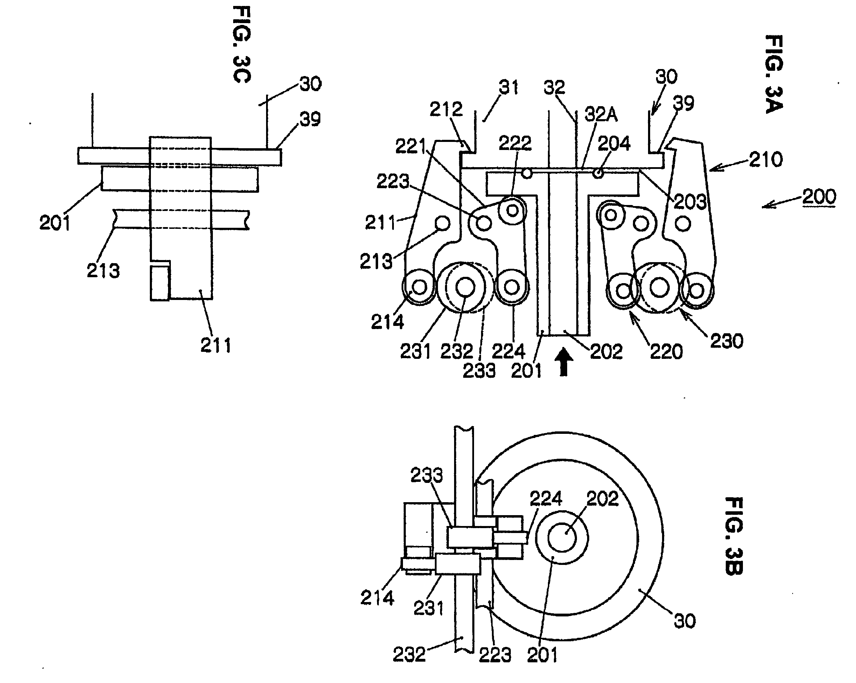

FIGS. 3A to 3C are explanatory views showing a connecting device 200 according to an embodiment 2 of the present invention. FIG. 3A is a front view of the connecting device 200, FIG. 3B is a view of the connecting device 200 seen from below, and FIG. 3C is a side view of the connecting device 200.

The connecting device 200 includes a base 201 formed with a communication port 202, a sealing ring 204 arranged on a surface 203 opposite the purge port 30, a holding part 210, a pressing part 220, a cam part 230 for driving the holding part 210 and the pressing part 220, etc. The sealing ring 204 is an O-ring, for example, and is arranged at the peripheral edge of the communication port 202.

The connecting device 200 includes a mechanism for pressing the base 201 against the purge port 30 by the pressing part 220 with the purge port 30 held by the holding part 210.

A concrete description will be made hereafter. The cam part 230 is arranged between the holding part 210 and the pressing part 220, and includes a holding cam 231, a pressing cam 233, etc. The holding cam 231 and the pressing cam 233 are arranged on a coaxial shaft 232. The holding cam 231 and the pressing cam 233 are shifted in phase to drive the pressing part 220 after driving the holding part 210.

The holding part 210 includes an engagement piece 211 rotatably supported on a shaft 213. The engagement piece 211 has one end formed with a claw 212 that engages with a flange 39 arranged in the purge port 30, and the other end formed with a holding abutment 214 that abuts on the holding cam 231. With the engagement piece 211, the holding abutment 214 abutting on the holding cam 231 is displaced with rotation of the shaft 232 to thereby engage the claw 212 with the flange 39, holding the purge port 30.

The pressing part 220 includes a pressing piece 221 rotatably supported on a shaft 223. The pressing piece 221 has one end formed with a contact 222 that moves the base 201 to the purge port 30, and the other end formed with a pressing abutment 224 that abuts on the pressing cam 233. With the pressing piece 221, the pressing abutment 224 abutting on the pressing cam 233 is displaced with rotation of the shaft 232 to thereby press the base 201 against the purge port 30 until the purge port 30 and the opposite surface 203 make close contact with each other.

Next, operation of the connecting device 200 will be described. FIG. 3A shows on the left side a state in which the purge port 30 and the base 201 are in close contact with each other, and on the right side a state in which the close-contact state is released.

First, operation of achieving the close-contact state by the connecting device 200 will be described.

With the connecting device 200, the holding abutment 214 abutting on the holding cam 231 is displaced with rotation of the shaft 232. With this, the engagement piece 211 is rotated counterclockwise (right side in FIG. 3A) so that the claw 212 of the holding part 210 engages with the flange 39. Engagement of the claw 212 with the flange 39 ensures holding of the purge port 30, obtaining stabilized position thereof.

Then, with the connecting device 200, the pressing abutment 224 abutting on the pressing cam 233 is displaced with rotation of the shaft 232. With this, the pressing piece 221 is rotated clockwise (right side in FIG. 3A) so that the contact 222 of the pressing part 220 makes contact with the base 201. Moreover, the contact 222 presses the base 201 against the purge port 30 until the purge port 30 and the opposite surface 203 make close contact with each other with rotation of the shaft 232.

Next, operation of releasing the close-contact state by the connecting device 200 will be described.

With the connecting device 200, the pressing abutment 224 abutting on the pressing cam 233 is displaced with rotation of the shaft 232. With this, the pressing piece 221 is rotated clockwise (left side in FIG. 3A) so that the contact 222 of the pressing part 220 separates from the base 201.

Then, with the connecting device 200, the holding abutment 214 abutting on the holing cam 231 is displaced with rotation of the shaft 232. With this, the engagement piece 211 is rotated counterclockwise (left side in FIG. 3A) so that the claw 212 of the holding part 210 separates from the flange 39.

With the connecting device 200, the claw 212 of the engagement piece 211 engages with the flange 39 of the purge port 30 with rotation of the holding cam 231 and pressing cam 233 having different phases, and the contact 222 of the pressing piece 221 moves the base 201 to the purge port 30. Thus, even when the flow rate of purge gas is increased, the purge port 30 can surely be positioned. Therefore, even if the separating force due to the flow rate of purge gas occurs in the wafer carrier 10, the connecting device 200 does not separate from the wafer carrier 10 to stabilize the position of the wafer carrier 10. Moreover, the flow rate of purge gas can be increased to reduce the purge time.

Various changes and modifications can be made without being limited to the embodiments described above, and they are also within the scope of the equivalents of the present invention.

The aforementioned groove 104 is annularly formed in the opposite surface 103. Without being limited thereto, the groove 104 may not annularly be formed on condition that the gas inlet 32 and the communication port 102 can be brought into close contact with each other by reducing the pressure in the space with the vacuum pump or the like.

The aforementioned engagement piece 211 is driven by the holding cam 231, and the pressing piece 221 is driven by the pressing cam 233. Without being limited thereto, a solenoid, air cylinder, or the like may be used to drive the engagement piece 211 so as to engage the claw 212 with the flange 39 and the pressing piece 221 so as to press the contact against the base 201.

The aforementioned connecting device 200 may be configured to use an air cylinder in place of the pressing part 220. Specifically, the connecting device 200 may be configured to directly press the base 201 by the pressing force of the air cylinder obtained by appropriately adjusting the pressure thereof.

The aforementioned connecting device 200 may be configured to provide an appropriate cushioning spring to the contact 222 of the pressing piece 221, etc. Specifically, the connecting device 200 may be configured to appropriately adjust the force that the pressing piece 221 presses the base 201 using such cushioning spring. With this, the connecting device 200 can be increased in durability, leading to potential of the long-term use.

## Claims

1. A connecting device (100, 200) provided to a wafer storage container (10) for storing a wafer (1) and connected to an atmosphere purge port (30) having a gas inlet (32) into which gas for purging an atmosphere in the wafer storage container (10) flows, the connecting device (100) comprising:
a base (101, 201);
a communication port (102, 202) formed in the base (101); and
a close-contact mechanism that brings the gas inlet (32) into close contact with the communication port (102, 202).

2. The connecting device (100) according to claim 1, **characterized in that** the close-contact mechanism includes:
a sealing part (105, 106) arranged on a surface (103) opposite to the atmosphere purge port (30);
a groove (104) formed in the opposite surface (103); and
a pressure-reducing part that reduces the pressure in a space defined by the groove (104) and a peripheral edge (32A) of the gas inlet (32) at a position where the base (101) makes contact with the atmosphere purge port (30).

3. The connecting device according to claim 2,
**characterized in that** the pressure-reducing part includes:
a pressure-reducing passage (107) that communicates with the groove (104); and
a conveying part connected to the pressure-reducing passage, the conveying part conveying air in the space to the outside.

4. The connecting device according to claim 2, **characterized in that** the sealing part includes a sealing ring (105, 106) arranged at a peripheral edge (32A) of the communication port (102).

5. The connecting device (200) according to claim 1, **characterized in that** the close-contact mechanism includes:
a sealing part (204) arranged on a surface opposite to the atmosphere purge port (30);
a holding part (210) that holds the atmosphere purge port (30); and
a pressing part (220) that presses the opposite surface against the atmosphere purge port (30) held by the holding part (210).

6. The connecting device according to claim 5,
**characterized in that** the holding part (210) includes:
an engaging part (211) that engages with a flange (39) formed with the atmosphere purge port (30);
a first cam part (231) that drives the engaging part (211); and
a first abutment (214) that abuts on the cam part (231),
wherein by displacing the first abutment (214) in a state of abutting the first cam part (231), the engaging part (211) engages with the flange (39).

7. The connecting device according to claim 6, **characterized in that** the pressing part (220) includes:
a moving part (221) that moves the base (201);
a second cam part (233) that drives the moving part (221); and
a second abutment (224) that abuts on the second cam part (233),
wherein by displacing the second abutment (224) in a state of abutting the second cam part (233), the moving part (221) presses the base (201) against the atmosphere purge port (30).

8. The connecting device according to claim 6,
**characterized in that** the first cam part (231) and the second cam part (233) are arranged coaxially, and are shifted in phase to drive the pressing part (220) after driving the holding part (210).

9. The connecting device according to claim 5,
**characterized in that** the sealing part (204) is disposed at a peripheral edge of the communication port (202).
